# EUROPÄISCHE PATENTSCHRIFT

(11) **EP 1 133 057 B1**
(45) Veröffentlichungstag und Bekanntmachung des Hinweises auf die Patenterteilung: **12.11.2008**
(21) Anmeldenummer: 01105768.4
(22) Anmeldetag: 08.03.2001
(51) Int. Cl.: H03K 17/96

(54) **Berührungsschalter mit einem LC-Display**
Touch switch with LC display
Commutateur à effleurement avec affichage à cristal liquide

(30) Priorität: 10.03.2000 DE 10011645
(43) Veröffentlichungstag der Anmeldung: 12.09.2001
(73) Patentinhaber: E.G.O. ELEKTRO-GERÄTEBAU GmbH, 75038 Oberderdingen (DE)
(72) Erfinder: Baier, Martin, 76275 Ettlingen (DE)
(74) Vertreter: Patentanwälte Ruff, Wilhelm, Beier, Dauster & Partner

(56) Entgegenhaltungen:
- DE-C- 4 041 144
- US-A- 4 224 615
- US-A- 4 529 968
- US-A- 5 043 710

## Beschreibung

Die Erfindung betrifft einen Berührungsschalter oder eine Berührungsschaltereinheit, insbesondere für ein Elektro-Gerät, mit einem LC-Display, wobei das LC-Display mindestens zwei parallele aufeinanderliegende Platten aufweist, zwischen denen leitfähige und mit Anschlüssen versehene Schichten bzw. Schichtabschnitte zur Darstellung einzelner Segmente des LC-Displays angeordnet sind. Zwischen den Schichten befindet sich ein Flüssigkristall. An der vorderen Platte ist vorteilhaft ein Polarisationfilter angebracht. Unter der unteren Platte befinden sich entweder eine Hinterleuchtung und ein Polarisationsfilter (transmissiver Typ) oder eine Reflexionsschicht (reflexiver Typ). Über die Anschlüsse sind die leitfähigen Schichten zur Darstellung der Segmente von außen auf übliche Weise ansteuerbar (gegenpolig zur Darstellung eines Segmentes mittels einer dunklen Fläche).

LC-Displays werden in vielen Gebieten eingesetzt zur Anzeige von Informationen, beispielsweise in kleinem Format in Uhren oder in größerem Format in Anzeigen von Elektro-Geräten oder Notebook-Bildschirmen. Dabei zeigt beispielsweise das LC-Display einen Zustand an, der über Schalter o.dgl. an dem Gerät nach Belieben veränderbar ist. Das Dokument US-A-5 093 718 offenbart eine Kombination eines Schalters mit einen LCD Display.

### AUFGABE UND LÖSUNG

Der Erfindung liegt die Aufgabe zugrunde, einen Berührungsschalter der eingangs genannten Art zu schaffen, der eine Kombination eines LC-Displays mit einem Berührungsschalter ermöglicht.

Gelöst wird diese Aufgabe durch einen Berührungsschalter mit den Merkmalen des Anspruchs 1. Vorteilhafte Ausgestaltungen der Erfindung sind Gegenstand der weiteren Ansprüche und werden im folgenden beschrieben.

Erfindungsgemäß ist unterhalb der Oberfläche des LC-Displays wenigstens ein Sensorelement des Berührungsschalters angeordnet, wobei der Berührungsschalter durch Berühren der Oberfläche des LC-Displays oberhalb des Sensorelements betätigbar ist. Somit kann einerseits die Möglichkeit geschaffen werden, durch ein einziges Einbaumodul, das vorgefertigt werden kann, sowohl eine Anzeige als auch eine Schaltereinheit bereitzustellen. Des weiteren ist es vorteilhaft möglich, durch die Anzeige mit den LCD-Segmenten die genaue Position der Berührungsschalter anzuzeigen, beispielsweise für "+" oder "-"-Anzeigen oder direktes Betätigen eines "off"-Feldes. Derartige Displays können in Elektro-Geräte eingebaut werden und sowohl als Funktionsanzeigen als auch als Betätigungsfelder, ähnlich Schaltern, dienen. Als weiteres Beispiel können damit Fernbedienungen o.dgl. mit großen Displays ausgerüstet werden, wobei verschiedene Anzeigen Funktionszustände des Geräts anzeigen. Durch Betätigen der zugehörigen Sensorelemente bzw. Berührungsschalter infolge Auflegen eine Fingers auf die Displayoberfläche kann dieser Funktionszustand verändert werden. Sowohl Anzeige von Funktionszuständen als auch zugehörige Schaltfunktion können variabel sein, beispielsweise aufgeteilt in mehrere Unterfunktionen.

Gemäß einer Ausführunsgmöglichkeit kann das wenigstens eine Sensorelement im Bereich der Segmente des LC-Displays angeordnet sein. Besonders geeignet ist ein Bereich zwischen verschiedenen Segmenten oder innerhalb eines offenen Segmentes, das beispielsweise wie ein Rahmen das Berührungsfeld anzeigt.

Es ist möglich, das wenigstens eine Sensorelement unter der unteren Platte anzuordnen. Bevorzugt ist es dabei separat davon und trennbar ausgebildet, so daß Standardkomponenten verwendet werden können.

Gemäß einer Möglichkeit kann der Berührungsschalter eine Reflexlichtschranke als Sensorelement aufweisen mit einer Lichtsendeeinrichtung und einer Lichtempfangseinrichtung. Dabei kann vorteilhaft die Reflexlichtschranke ohne Rücksicht auf die Anordnung der leitfähigen Schichten des LC-Displays positionierbar sein. Es muß lediglich beachtet werden, daß ein dargestelltes Segment die Lichtbahn stören würde, deshalb sollte kein Segment in der Lichtbahn liegen. Es bietet sich insbesondere eine Verwendung von IR-Licht an. Zur Energieeinsparung sowie zur Vermeidung von Störungen durch eingestreutes Licht von außen kann die Reflexlichtschranke im Intervallbetrieb betrieben werden, insbesondere arbeiten dabei die Sende- und die Empfangseinrichtung im Intervallbetrieb.

Gemäß einer grundsätzlichen anderen Ausführungsmöglichkeit kann das Sensorelement als kapazitives Sensorelement ausgebildet sein. Einmal kann dies in Form eines flexiblen leitfähigen Schaumstoffkörpers sein, beispielsweise eines Schaumstoffzylinders. Ein solches Sensorelement ist an einer Stelle des LC-Displays ohne Segmente bzw. leitfähige Schicht darüber angeordnet. Die an die untere Platte des Displays angelegte Fläche des Schaumstoffkörpers wirkt wie die eine Kondensatorplatte eines kapazitiven Sensorelements. Derartige Sensorelemente sind in ihrer Funktionsweise hinreichend bekannt.

Gemäß einer weiteren Ausführungsmöglichkeit eines kapazitiven Sensorelements kann eine leitfähige Sensorschicht bzw. ein Sensorschichtabschnitt zwischen den Platten bzw. auf einer der Innenseiten der Platten des LC-Displays als Sensorfläche angeordnet sein. Somit wird das Sensorelement in das LC-Display nicht nur funktional sondern vollständig integriert. Bevorzugt liegt die Sensorschicht in der Ebene einer der beiden leitfähigen Schichten des LC-Displays. Es kann sich um eine gesondert aufgebrachte Schicht handeln. Besonders bevorzugt wird die Sensorschicht bzw. der -schichtabschnitt von einer der beiden leitfähigen Schichten des LC-Displays gebildet, wobei sie von den zur Darstellung der Segmente benötigten Schichtbereichen elektrisch getrennt ist.

Es ist in weiterer Ausgestaltung der Erfindung möglich, daß die Sensorschicht von einem Abschnitt wenigstens einer der beiden leitfähigen Schichten gebildet wird in einem Bereich bzw. von einem Abschnitt, der zur Segmentdarstellung nutzbar ist. Dabei ist das LC-Display im Wechselbetrieb mit mindestens zwei Betriebsarten ansteuerbar. Die leitfähigen Schichten werden über die Anschlüsse einerseits gegenpolig zur Segmentdarstellung und andererseits getrennt oder vorteilhaft kurzgeschlossen als Sensorelement betrieben. Das heißt, es erfolgt eine Segmentdarstellung im Wechsel mit der Sensorelementfunktion. Der Wechsel sollte dabei so schnell vor sich gehen, daß das menschliche Auge eine permanente Segmentdarstellung wahrnimmt, beispielsweise mit einer Frequenz von über 50 Hz bis zu einigen hundert Hz. Die leitfähigen Schichten können mit einem Wechselstrom angesteuert werden, insbesondere mit einer Frequenz von 30 kHz bis 100 kHz für die Sensorelementfunktion.

Diese und weitere Merkmale gehen außer aus den Ansprüchen auch aus den Beschreibungen und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ausführungsbeispiele der Erfindung sind in den Zeichnungen dargestellt und werden im folgenden näher erläutert. In den Zeichnungen zeigen:
- Fig. 1: Schnitt durch ein LC-Display mit einem darunter angeordneten Schaumstoffsensorelement und einer Reflexlichtschranke,
- Fig. 2: Draufsicht auf ein LC-Display gemäß Fig. 1,
- Fig. 3: Schnitt durch ein LC-Display mit auch als Sensorelement betriebenen Schichtabschnitten zur Segmentdarstellung und
- Fig. 4: Draufsicht auf ein LC-Display gemäß Fig. 3.

### DETAILLIERTE BESCHREIBUNG DER AUSFÜHRUNGSBEISPIELE

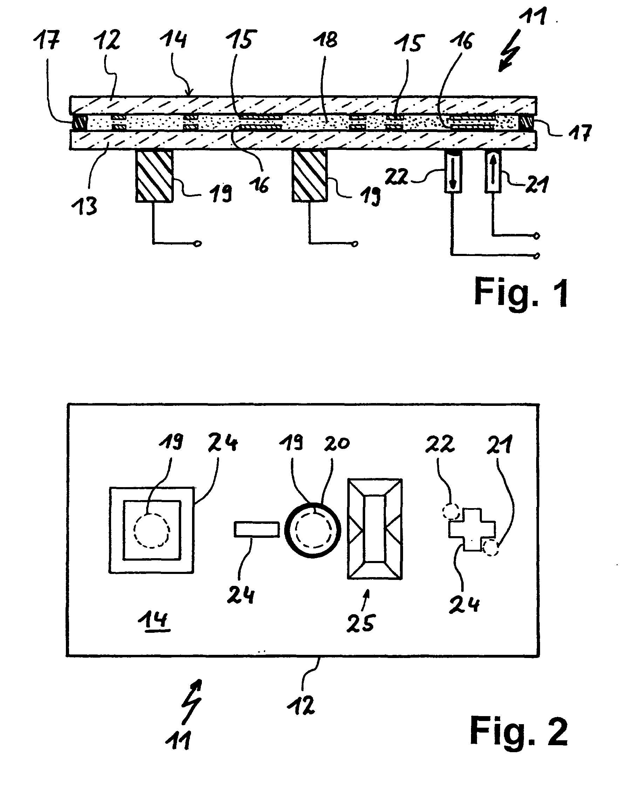

Die Fig. 1 zeigt ein LC-Display 11 im Schnitt, das eine obere Glasplatte 12 und eine untere Glasplatte 13 aufweist. Anstelle von Glasplatten können andere transparente Materialien verwendet werden, beispielsweise aus Kunststoff. Zwischen den Glasplatten 12 und 13 befinden sich eine obere leitfähige Schicht 15 und eine untere leitfähige Schicht 16, die in einzelne Abschnitte unterteilt sind. Diese Unterteilung entspricht von den Umrissen den darzustellenden LCD-Symbolen, siehe Fig. 2. Seitlich sind die Glasplatten 12 und 13 durch eine Verklebung 17 verbunden. Zwischen den Glasplatten, auch zwischen den Schichten 15 und 16, befindet sich ein Flüssigkristall 18. Im wesentlichen ist dies der grundlegende Aufbau eines LC-Displays.

Die untere leitfähige Schicht 16 kann von den Umrissen her auch abweichend bzw. größer sein als die obere Schicht 15. Es ist aber zu beachten, daß einerseits zumindest die Abschnitte der oberen Schicht abgedeckt werden. Andererseits sollten die Anschlüsse für die obere Schicht nicht abgedeckt werden. Ein Layout für die beiden Schichten 15 und 16 kann ähnlich zu einem Leiterplatten-Layout aufgebaut sein.

In der Regel befindet sich an der Vorderseite auf der Oberfläche 14 noch ein Polarisationsfilter, der hier der Übersichtlichkeit halber weggelassen wurde. Des weiteren weist ein übliches LC-Display hinter der unteren Glasplatte 13 entweder eine Reflexionsschicht oder eine Hinterleuchtung und einen Polarisationsfilter auf. Auch auf diese ist hier bei der Darstellung verzichtet worden.

Unter dem LC-Display 11 sind, angelegt an die Unterseite der unteren Glasplatte 13, an der linken Seite zwei Schaumstoff-Sensorelemente 19 aus leitfähigem Schaumstoff dargestellt. Schaumstoff-Sensorelemente dieser Art sind beispielsweise in der DE 197 06 168 beschrieben. Die an der Glasplatte anliegende Fläche des Sensorelements 19 bildet die ansonsten übliche leitfähige Fläche eines kapazitiven Sensorelements. Die Ansteuerung und Auswertung sind nicht dargestellt, können jedoch der oben genannten Anmeldung entnommen werden.

Beide Sensorelemente 19 sind an derart plaziert, daß über ihnen kein Abschnitt der oberen leitfähigen Schicht 15 oder 16 verläuft. Dies würde die kapazitiven Sensorelemente außer Funktion setzen, da sich dann keine elektrischen Feldlinien bilden können über dem Sensorelement. Ebenso dürfen keine Anschlußbahnen für die Schichtabschnitte darüber verlaufen. Eine nicht metallische Reflexionsschicht stört in der Regel nicht.

An der rechten Seite sind unter dem LC-Display eine Lichtsendeeinrichtung 21 und eine Lichtempfangseinrichtung 22 angeordnet nach dem Prinzip einer Reflexlichtschranke. Die Lichtsendeeinrichtung 21 strahlt Licht aus, vorzugsweise im IR-Bereich. Durch Auflegen eines Fingers oberhalb davon wird ein Teil des Lichts nach unten reflektiert und von der Lichtempfangseinrichtung 22 aufgefangen und ausgewertet als Auslösung des Berührungsschalters. Die Anordnung der Reflexlichtschranke ist grundsätzlich unabhängig von leitfähigen Schichten, allerdings darf kein LC-Symbol im Lichtweg zwischen Sendeeinrichtung und Empfangseinrichtung liegen.

Dies ist nur dann möglich, wenn das Licht das LC-Symbol durchdringen kann, beispielsweise bei geeigneter Wellenlänge.

Die Fig. 2 zeigt das LC-Display 11 aus Fig. 1 in Draufsicht. Es ist zu erkennen, daß sich unter einem LCD-Feld 24 das linke Sensorelement 19 befindet. Das LCD-Feld 24 kann so, evtl. situationsabhängig, auf das Betätigen dieses Sensorelements durch Auflegen eines Fingers auf die Oberfläche 14 der oberen Glasplatte 12 hinweisen. Das rechte Sensorelement 19 ist unter einer auf die Oberfläche 14 aufgetragenene Markierung 20 plaziert.

Die von der Sende- und Empfangseinrichtung 21 und 22 gebildete Reflexlichtschranke ist schräg auseinanderliegend unter einem LCD-Feld 24 in Form eines Plus-Zeichens angeordnet. Falls also eine Betätigung in irgendeiner Weise höherwertig o.dgl. erfolgen soll, kann direkt das Plus-Symbol 24 betätigt werden bzw. ein Finger darauf gelegt werden. Dazwischen ist eine übliche LCD-Ziffer 25 dargestellt, deren Wert z.B. durch das Plus-Symbol verändert werden kann.

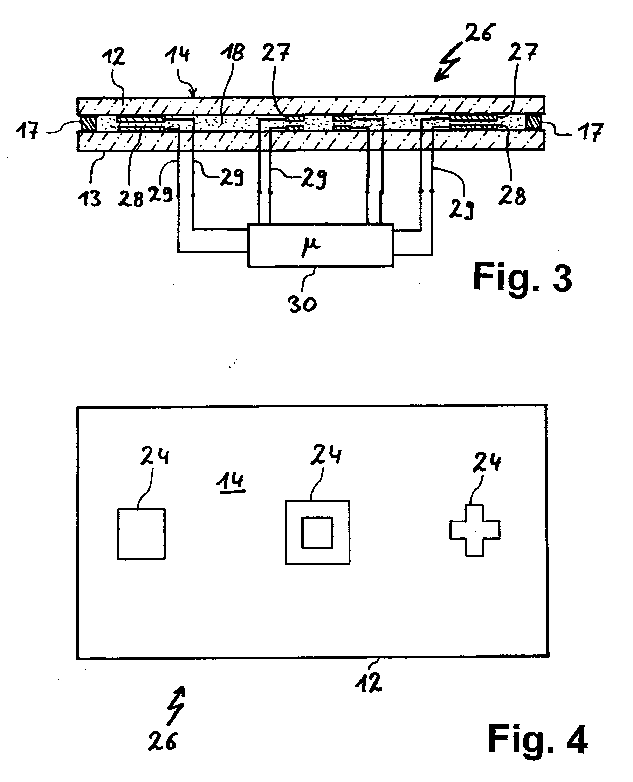

Die Fig. 3 zeigt ein LC-Display 26 mit zwei Glasplatten 12 und 13 und Flüssigkristall 18. Die beiden Glasplatten tragen ähnlich Fig. 1 in Abschnitte unterteilt eine obere leitfähige Schicht 27 und eine untere leitfähige Schicht 28, deren Form aus der Fig. 4 ersichtlich ist. Die einzelnen Abschnitte sind jeweils mit elektrischen Anschlüssen 29 versehen, die ähnlich Leiterplattenbahnen aus dem LC-Display herausgeführt und an einen *µ*-Prozessor 30 angeschlossen sind. So kann jeder einzelne Abschnitt der Schichten separat angesteuert werden. Auf die Darstellung der Führung der Anschlüsse 29 ist hier verzichtet worden. Aus der Fig. 4 ist ersichtlich, wie die einzelnen LCD-Felder 24 im LCD-Betrieb aussehen.

Das LC-Display 26 ist für den Intervallbetrieb der leitfähigen Schichten 27 und 28 sowohl als LCD-Anzeige als auch als kapazitiver Berührungsschalter ausgelegt. Über die elektrischen Anschlüsse 29 können die einzelnen Abschnitte der Schichten 27 und 28 einerseits als LCD-Anzeige angesteuert werden. Dazu werden die Schichten gegenpolig angesteuert wie bei einem normalen LCD-Display.

Andererseits können die Schichten über die Anschlüsse 29 kurzgeschlossen werden bzw. die Felder der oberen Schicht 27 als kapazitiver Berührungsschalter bzw. als Sensorfläche dafür angesteuert werden. Dann kann allerdings kein LCD-Symbol dargestellt werden. Besonders vorteilhaft ist es, beide Betriebsarten im Intervallbetrieb so schnell abwechselnd auszuführen, daß im Endeffekt beides möglich ist. Es kann beispielsweise mit einer Frequenz von über 50 Hz, besser über 70 Hz, abwechselnd in den LCD-Betrieb und in den Berührungsschalterbetrieb gewechselt werden. Dadurch ist einerseits für den Benutzer das LCD-Symbol permanent sichtbar und andererseits der Berührungsschalter quasi ständig aktiviert. Darüber hinaus ist es möglich, die jeweiligen Verweilzeiten unterschiedlich auszulegen, beispielsweise für den LCD-Betrieb länger als für den Berührungsschalterbetrieb.

Als Voraussetzung für diese Betriebsart gilt, daß der Abschnitt der Schicht, der zum Sensorelement wird, nicht mit dem übrigen Bereich der Schicht, insbesondere der unteren Schicht, verbunden sein darf. Über diesen Abschnitt hinweg dürfen auch keine Bahnen für die Anschlüsse 29 führen. Wird ein Abschnitt einer Schicht als Sensorelement betrieben, dem ein Abschnitt der anderen Schicht zur LC-Darstellung gegenüber angeordnet ist, so sind die beiden Abschnitte für die Dauer der Sensorelementfunktion kurzzuschließen.

## Patentansprüche

1. Berührungsschalter, insbesondere für ein Elektro-Gerät, mit einem LC-Display (11, 26), wobei das LC-Display zwei parallele aufeinanderliegende Platten (12, 13) aufweist, zwischen denen leitfähige und mit Anschlüssen (29) versehene Schichten (15, 16; 27, 28) zur Darstellung einzelner Segmente (24, 25) des LC-Displays angeordnet sind, wobei unterhalb der Oberfläche (14) des LC-Displays wenigstens ein Sensorelement (19, 21, 22, 27) des Berührungsschalters angeordnet ist, **dadurch gekennzeichnet, dass** der Berührungsschalter durch Berührung der Oberfläche des LC-Displays oberhalb des Sensorelements betätigbar ist und wobei das Sensorelement (19, 27) als kapazitives Sensorelement ausgebildet ist.

2. Berührungsschalter nach Anspruch 1, **dadurch gekennzeichnet, dass** das wenigstens eine Sensorelement (19, 21, 22) im Bereich der Segmente (24, 25) des LC-Displays (11, 26) angeordnet ist, insbesondere in einem Bereich zwischen verschiedenen Segmenten oder innerhalb eines offenen Segmentes.

3. Berührungsschalter nach Anspruch 1, **dadurch gekennzeichnet, dass** das Sensorelement ein flexibler leitfähiger Schaumstoffkörper (19) ist, wobei der Schaumstoffkörper an einer Stelle des LC-Displays (11) ohne Segmente (24, 25) und/oder leitfähige Schicht (15) und Anschlüsse (29) darüber angeordnet ist.

4. Berührungsschalter nach Anspruch 1, **dadurch gekennzeichnet, dass** das Sensorelement eine leitfähige Sensorschicht (27) zwischen den Platten (12, 13) des LC-Displays (26) als Sensorfläche aufweist.

5. Berührungsschalter nach Anspruch 4, **dadurch gekennzeichnet, dass** die Sensorschicht in der Ebene einer der beiden leitfähigen Schichten (27, 28) des LC-Displays (26) liegt, vorzugsweise der oberen Schicht (27).

6. Berührungsschalter nach Anspruch 4 oder 5, **dadurch gekennzeichnet, dass** die Sensorschicht von mindestens einer der beiden leitfähigen Schichten (27, 28) des LC-Displays (26) gebildet wird, wobei sie von den zur Darstellung der Segmente (24, 25) benötigten Schichtabschnitten elektrisch getrennt ist.

7. Berührungsschalter nach Anspruch 4 oder 5, **dadurch gekennzeichnet, dass** die Sensorschicht von wenigstens einer der beiden leitfähigen Schichten (27, 28) gebildet wird in einem Abschnitt, der zur Segmentdarstellung nutzbar ist, wobei das LC-Display (26) im Wechselbetrieb ansteuerbar ist und wobei die leitfähigen Schichten über die Anschlüsse (29) in zwei Betriebsarten einerseits gegenpolig zur Segmentdarstellung und genpolig zur Segmentdarstellung und andererseits kurzgeschlossen als Sensorelement betrieben werden.

8. Berührungsschalter nach Anspruch 7, **dadurch gekennzeichnet, dass** die leitfähigen Schichten (27, 28) mit einem Wechselstrom angesteuert werden, insbesondere mit einer Frequenz von 30 kHz bis 100 kHz für die Sensorelementfunktion, wobei vorzugsweise die Frequenz des Wechsels zwischen den Betriebsarten mindestens 50 Hz beträgt.

## Claims

1. Touch contact switch, particularly for an electrical appliance, having a LCD (11, 26), which has two parallel, superimposed plates (12,13), between which are provided conductive layers (15, 16; 27, 28) having terminals (29) for the display of individual segments (24, 25) of the LCD and below the surface (14) of the LCD is provided at least one sensor element (19, 21, 22, 27) of the touch contact switch, **characterized in that** the touch contact switch is operable by contacting the surface of the LCD above the sensor element (19, 27), which is constructed as a capacitive sensor element.

2. Touch contact switch according to claim 1, **characterized in that** the at least one sensor element (19, 21, 22) is placed in the vicinity of the segments (24, 25) of the LCD (11, 26), particularly in an area between different segments or within an open segment.

3. Touch contact switch according to claim 1, **characterized in that** the sensor element is a flexible, conductive foam body (19), which is located at a point of the LCD (11) not having segments (24, 25) and/or conductive layer (15) and terminals (29) above the same.

4. Touch contact switch according to claim 1, **characterized in that** the sensor element has a conductive sensor layer (27) between the plates (12, 13) of the LCD (26) as a sensor surface.

5. Touch contact switch according to claim 4, **characterized in that** the sensor layer is in the plane of one of the two conductive layers (27, 28) of the LCD (26), preferably the upper layer (27).

6. Touch contact switch according to claim 4 or 5, **characterized in that** the sensor layer is formed by at least one of the two conductive layers (27, 28) of the LCD (26) and is electrically isolated from the layer portions required for displaying the segments (24, 25).

7. Touch contact switch according to claim 4 or 5, **characterized in that** the sensor layer is formed by at least one of the two conductive layers (27, 28) in a portion usable for segment display, the LCD (26) being activatable in alternating operation and in which the conductive layers are operated by means of the terminals (29) in two operating modes on the one hand in antipole manner for segment display and on the other in short-circuited manner as a sensor element.

8. Touch contact switch according to claim 7, **characterized in that** the conductive layers (27, 28) are activated with an alternating current, particularly having a frequency of 30 to 100 kHz for the sensor element function and preferably the frequency of the alternation between the modes is at least 50 Hz.

## Revendications

1. Commutateur à effleurement, notamment pour un appareil électrique, avec un affichage à cristaux liquides (11, 26), où l'affichage à cristaux liquides présente deux plaques (12, 13) parallèles, l'une étant posée sur l'autre, entre lesquelles sont disposées des couches (15, 16 ; 27, 28) conductibles et munies de contacts (29) pour l'affichage de segments (24, 25) individuels de l'affichage à cristaux liquides, sachant qu'au-dessous de la surface (14) de l'affichage à cristaux liquides est disposé au moins un élément détecteur (19, 21, 22, 27) du commutateur à effleurement, **caractérisé en ce que** le commutateur à effleurement peut être actionné en touchant la surface de l'affichage à cristaux liquides au-dessus de l'élément détecteur et sachant que l'élément détecteur (19, 27) est réalisé en tant qu'élément détecteur capacitif.

2. Commutateur à effleurement d'après la revendication 1, **caractérisé en ce qu'**au moins un élément détecteur (19, 21, 22) est disposé dans la zone des segments (24, 25) de l'affichage à cristaux liquides (11, 26), notamment dans la zone entre différents segments ou à l'intérieur d'un segment ouvert.

3. Commutateur à effleurement d'après la revendication 1, **caractérisé en ce que** l'élément détecteur est un corps alvéolaire (19) flexible et conductible, sachant que le corps alvéolaire est disposé à un endroit au-dessus de l'affichage à cristaux liquides (11), où des segments (24, 25) et/ou une couche conductible (15) et des contacts (29) ne sont pas présents.

4. Commutateur à effleurement d'après la revendication 1, **caractérisé en ce que** l'élément détecteur présente en tant que surface de détection une couche de détection (27) conductible située entre les plaques (12, 13) de l'affichage à cristaux liquides (26).

5. Commutateur à effleurement d'après la revendication 4, **caractérisé en ce que** la couche de détection est située dans le plan d'une des deux couches conductibles (27, 28) de l'affichage à cristaux liquides (26), de préférence dans le plan de la couche supérieure (27).

6. Commutateur à effleurement d'après la revendication 4 ou 5, **caractérisé en ce que** la couche de détection est constituée d'au moins une des deux couches conductibles (27, 28) de l'affichage à cristaux liquides (26), sachant qu'elle est séparée électriquement des parties de la couche qui servent à l'affichage des segments (24, 25).

7. Commutateur à effleurement d'après la revendication 4 ou 5, **caractérisé en ce que** la couche de détection est constituée d'au moins une des deux couches conductibles (27, 28) dans une zone utilisable pour l'affichage des segments, sachant que l'affichage à cristaux liquides (26) peut être commandé tour à tour et sachant que les couches conductibles sont actionnées au moyen des contacts (29) en deux modes opératoires, d'une part à pôles inversés par rapport à l'affichage des segments et d'autre part en court-circuit en tant qu'élément détecteur.

8. Commutateur à effleurement d'après la revendication 7, **caractérisé en ce que** les couches conductibles (27, 28) sont commandées par un courant alternatif, présentant notamment une fréquence entre 30 kHz et 100 kHz pour la fonction des éléments détecteur, sachant que de préférence la fréquence de l'alternance entre les modes opératoires comporte au moins 50 Hz.
